# EUROPEAN PATENT SPECIFICATION

(11) **EP 3 017 327 B1**
(45) Date of publication and mention of the grant of the patent: **01.09.2021**
(21) Application number: 14819302.2
(22) Date of filing: 26.06.2014
(51) Int. Cl.: G02B 5/12

(54) **RETROREFLECTIVE SHEETING INCLUDING A SOLVENT-BASED TOPCOAT**
RÜCKSTRAHLENDE FOLIE MIT EINER DECKSCHICHT AUF LÖSUNGSMITTELBASIS
FEUILLE RÉTRORÉFLÉCHISSANTE COMPRENANT UNE COUCHE DE FINITION À BASE D'UN SOLVANT

(30) Priority: 01.07.2013 US 201361841522 P
(43) Date of publication of application: 11.05.2016
(73) Proprietor: 3M Innovative Properties Company, St. Paul, MN 55133-3427 (US)
(72) Inventor: PAVELKA, Lee A., Saint Paul, MN 55133-3427 (US); MEITZ, David W., Saint Paul, MN 55133-3427 (US); RICHIE, Joseph A., Saint Paul, MN 55133-3427 (US); KUSILEK, Thomas V., Saint Paul, MN 55133-3427 (US); LEVERTY, Mark W., Saint Paul, MN 55133-3427 (US)
(74) Representative: Vossius & Partner Patentanwälte Rechtsanwälte mbB
(86) International application number: PCT/US2014/044365
(87) International publication number: WO 2015/002814

(56) References cited:
- WO-A1-02/21167
- GB-A- 2 489 952
- GB-A- 2 489 952
- US-A- 4 576 850
- US-A- 5 189 553
- US-B1- 6 514 594
- US-B1- 6 514 594
- None

## Description

### Technical Field

This disclosure relates generally to retroreflective sheeting including a topcoat and to methods of making such sheeting.

### Background

Retroreflective articles are characterized by the ability to redirect light incident on the material back toward the originating light source. This property has led to the widespread use of retroreflective articles in sheeting used in, for example, traffic and personal safety uses. Retroreflective sheeting is commonly employed in a variety of traffic control articles, for example, road signs, barricades, license plates, pavement markers and marking tape, as well as retroreflective tapes for vehicles and clothing.

Cube corner sheeting, sometimes referred to as prismatic, microprismatic, triple mirror, or total internal reflection sheetings, is one type of retroreflective sheeting, and it typically includes a multitude of cube corner elements to retroreflect incident light. Cube corner retroreflectors typically include a sheet having a generally planar front surface and an array of cube corner elements protruding from the back surface. Cube corner reflecting elements include generally trihedral structures that have three approximately mutually perpendicular lateral faces meeting in a single corner--a cube corner. In use, the retroreflector is arranged with the front surface disposed generally toward the anticipated location of intended observers and the light source. Light incident on the front surface enters the sheet and passes through the body of the sheet to be reflected by each of the three faces of the elements, so as to exit the front surface in a direction substantially toward the light source.

Some exemplary polymers for use in making cube corner sheeting include poly(carbonate), poly(methyl methacrylate), poly(ethylene terephthalate), aliphatic polyurethanes, as well as ethylene copolymers and ionomers thereof. Cube corner sheeting may be prepared by casting directly onto a film, such as described in U.S. Patent No. 5,691,846. Polymers for radiation-cured cube corners include cross-linked acrylates such as multifunctional acrylates or epoxies and acrylated urethanes blended with mono-and multifunctional monomers. Further, cube corners may be cast on to plasticized polyvinyl chloride film for more flexible cast cube corner sheeting. These polymers are often employed for one or more reasons including thermal stability, environmental stability, clarity, excellent release from the tooling or mold, and capability of receiving a reflective coating.

Prismatic retroreflective sheeting typically includes a thin transparent layer having a substantially planar first surface and a second structured surface including a plurality of geometric structures, some or all of which include three reflective faces configured as a cube corner element. Prismatic retroreflective sheeting is known for returning a large portion of the incident light towards the source. Many commercially available products rely on the relatively high retroreflectance (light return toward the source) provided by prismatic cube corner microstructures to meet high retroreflectance specifications (e.g., retroreflectance (R_{A}) or brightness in the range of 300 to 1000 candela per lux per meter square (cpl) for 0.2 degree observation angle and -4 entrance angle), such as ASTM types III, VII, VIII, IX, and X, as described in ASTM D 4956-04, and type XI, as described in ASTM D 4956-09. There are various types of prismatic retroreflective sheeting. One such type includes truncated cube corner elements and is described in, for example, U.S. Patent Nos. 3,712,706; 4,202,600; 4,243,618; and 5,138,488. Other types includes full or preferred geometry cube corner elements, as is described in, for example, U.S. Patent Nos. 7,156,527; 7,152,983; and 8,251,52.

Typically cube corner sheeting employs a topcoat layer that gives protection to the underlying cube corner layer and may add other functionality such as improved ink receptivity, dirt resistance, flexibility or rigidity, coloration, etc. Existing topcoats are typically either extruded films or waterborne acrylic compositions (see, *e.g.,* U.S. Patent No. 7,048,989). Some exemplary drawbacks of extruded films are that they are relatively thick and can impair sheeting flexibility and that they are expensive to manufacture. Some drawbacks of waterborne acrylic polymer compositions are that they are expensive and time-consuming to manufacture because they take extended periods of time and energy to remove the water by drying. The document US 4 576 850 A discloses a retro reflective sheeting comprising a plurality of prismatic cube corner elements and a topcoat adjacent to at least a portion of the second major surface, wherein the topcoat is a solvent-based composition including a UV absorber and has a thickness of less than 0.0127mm. The document GB 2 489 952 A discloses a retro reflective sheeting a topcoat adjacent to at least a portion of the second major surface, wherein the topcoat is a solvent-based composition comprising alkyd resin, wherein the topcoat includes a UV absorber and has a thickness less than 0.0127 mm. The document US 6 514 594 B1 discloses a retro reflective sheeting comprising a plurality of prismatic cube corner elements and a topcoat adjacent to at least a portion of the second major surface, wherein the topcoat is a solvent-based composition including between 3 % by weight and about 10 % by weight of a UV absorber.

### Summary

Existing topcoat materials for use with prismatic retroreflective sheeting are typically either (1) extruded or (2) water-based or aqueous-based. The inventors of the present disclosure recognized that improved retroreflective sheeting, and an improved method of making retroreflective sheeting, includes a solvent-based topcoat. Specifically, the inventors of the present disclosure discovered that, in some embodiments, solvent-based topcoat compositions provide a low cost and equally performing alternative to the use of water-based urethane or water-based acrylic topcoats. The inventors of the present disclosure discovered that, in some embodiments, the use of a solvent-based topcoat composition on retroreflective sheeting results in sheeting with at least one of sufficient adhesion to a retroreflective core sheet, a sheeting with high retroreflective brightness, excellent surface protection, good toner/ink adhesion properties, and/or decreased incidence of crazing and/or hazing. Also, the manufacturing process for making the sheeting is improved by at least one of efficiency, decreased cost, decreased solvent waste requirements, and the like.

The inventors of the present application also discovered methods of effectively and efficiently applying a solvent-based topcoat onto a polycarbonate-based retroreflective sheeting without creating significant craze or haze in the resulting retroreflective sheeting.

A main embodiment is defined in claim 1. Additional embodiments are defined in the dependent claims.

### Brief Description of Drawings

The disclosure may be more completely understood in consideration of the following detailed description of various embodiments of the disclosure in connection with the accompanying drawings.
Fig. 1 is a cross-sectional side view of an exemplary embodiment of retroreflective sheeting consistent with the teachings herein.
Fig. 2 is a cross-sectional side view of an exemplary embodiment of retroreflective sheeting consistent with the teachings herein.
Figs. 3A and 3B are cross-sectional side views of an exemplary embodiment of retroreflective sheeting consistent with the teachings herein.

### Detailed Description

In the following detailed description, reference may be made to the accompanying drawing that forms a part hereof and in which is shown by way of illustration one exemplary specific embodiment. It is to be understood that other embodiments are contemplated and may be made without departing from the scope of the present disclosure.

The present invention generally relates to retroreflective sheeting comprising prismatic cube corner element sheeting including a viewing surface on which incoming light is incident. A topcoat is disposed on the viewing surface. The topcoat includes a solvent-borne composition.

As used herein, the term "topcoat" refers to a layer disposed on the viewing surface (e.g. outermost surface on which incoming light is incident) of a piece of retroreflective sheeting. The topcoats described herein can, for example, assist in protecting the front surface of the retroreflective sheeting.

As used herein, the term "solvent-borne" or "solvent-based" refers to a polymer or composition that is dispersed or emulsified in a solvent.

As used herein, the term "water-borne," "water-based," "aqueous-borne," or "aqueous-based" refers to a polymer or composition that is dispersed or emulsified in water.

As used herein, the term "PG cube corner elements" or "preferred geometry cube corner elements" refers to a cube corner element that has at least one non-dihedral edge that: (1) is nonparallel to the reference plane; and (2) is substantially parallel to an adjacent non-dihedral edge of a neighboring cube corner element. A cube corner element whose three reflective faces comprise rectangles (inclusive of squares), trapezoids or pentagons are examples of PG cube corner elements. "Reference plane" with respect to the definition of a PG cube corner element refers to a plane or other surface that approximates a plane in the vicinity of a group of adjacent cube corner elements or other geometric structures, the cube corner elements or geometric structures being disposed along the plane. In the case of a single lamina, the group of adjacent cube corner elements consists of a single row or pair of rows. In the case of assembled laminae, the group of adjacent cube corner elements includes the cube corner elements of a single lamina and the adjacent contacting laminae. In the case of sheeting, the group of adjacent cube corner elements generally covers an area that is discernible to the human eye (e.g., preferably at least 1 mm2) and preferably the entire dimensions of the sheeting.

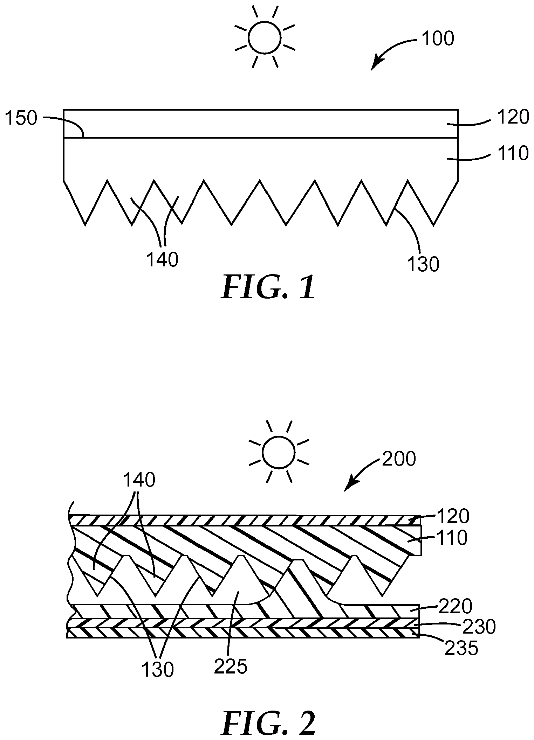

Fig. 1 shows an exemplary embodiment of retroreflective sheeting consistent with the teachings herein. Retroreflective sheeting 100 includes a prismatic cube corner element-based sheeting 110 and a topcoat 120 adjacent thereto. More specifically, prismatic cube corner element-based sheeting 110 includes a first major surface 130 that is structured by a plurality of cube corner elements 140 and an opposite, second major surface 150 that is substantially planar. Topcoat 120 is adjacent to second major surface 150.

Fig. 2 shows the retroreflective sheeting of Fig. 1 further including a seal film. More specifically, retroreflective sheeting 200 includes a prismatic cube corner element-based sheeting 110 and a topcoat 120 adjacent thereto. More specifically, prismatic cube corner element-based sheeting 110 includes a first major surface 130 that is structured by a plurality of cube corner elements 140 and an opposite second major surface 150 that is substantially planar. Topcoat 120 is adjacent to second major surface 150. A seal film 220 is adjacent to and forms an air interface 225 with structured surface 130 of cube corner elements 140. Adjacent to seal film 220 is an adhesive layer 230 and an optional release liner 235.

The prismatic cube corner sheeting of the present disclosure includes a plurality of microreplicated retroreflective elements. There are various types of prismatic retroreflective elements that can be used in the embodiments and inventions described and claimed herein. One such type includes truncated cube corner elements including, for example, those described in U.S. Patent Nos. 3,712,706; 4,202,600; 4,243,618; and 5,138,488. Other types includes full cube corner elements and preferred geometry cube corner elements, as are described in, for example, U.S. Patent Nos. 7,156,527; 7,152,983; and 8,251,52. Additional illustrative examples of cube corner-based retroreflective sheeting are disclosed in U.S. Patent Nos. 4,588,258; 4,775,219; 4,895,428; 5,387,458; 5,450,235; 5,605,761; 5,614,286; and 5,691,846.

In the main embodiment, the cube corner prismatic elements include polycarbonate. In some embodiments, the prismatic cube corner elements have a height ranging from 20 to 500 micrometers (µm).

As used herein, the term "body layer" refers to a separate material to which the microreplicated elements are attached, adhered, or adjacent (see, for example, Fig. 2). A body layer is optional. In some embodiments, microreplicated retroreflective elements of the types described herein are adhered, attached, or adjacent to a body layer. Some exemplary body layers have a thickness between about 20 and 1,000 µm. In some embodiments, both the body layer and microreplicated retroreflective elements include the same material. In some embodiments, the material is one or more light transmitting or transparent polymeric materials. In some embodiments, the body layer is a different material(s) than the microreplicated retroreflective elements. In some embodiments, the body layer may itself include more than one layer. In some embodiments where the body layer includes multiple layers, these layers can include more than one composition, and the composition can vary by layer. Some exemplary body layers are described in, for example, U.S. Patent No. 7,611,251. These materials include, for example, poly(ethylene-co-acrylic acid) and poly(ethylene-co-vinylacetate). In some embodiments, the body layer includes a polyolefin, typically comprising at least 50 weight percent (wt-%) of alkylene units having 2 to 8 carbon atoms (e.g., ethylene and propylene).

As used herein, the term "land layer" refers to a material adjacent to and integral with the microreplicated elements. A land layer is optional. Some embodiments include a land layer (not shown) integral with cube corner elements 12 which includes the same polymeric material as the cube corner elements. Cube corner retroreflective sheeting having a land layer is shown, for example, in U.S. Patent 5,450,235. In some embodiments, the land layer is thin by comparison to the microreplicated retroreflective elements, typically having a thickness no greater than 10 percent of the height of the cube corner elements. In some embodiments, land layer thickness is in the range of 1 - 150 µm. In some embodiments, land layer thickness is in the range of 10 - 100 µm.

Some embodiments include microreplicated retroreflective elements and a body layer without a land layer. Some embodiments include microreplicated retroreflective elements and a land layer without a body layer. Some embodiments include microreplicated retroreflective elements adjacent to a land layer which is adjacent to a body layer. In this latter instance, the body layer is often referred to as a top film or overlaminate.

Some embodiments of retroreflective sheeting include a specular reflective coating, such as a metallic coating, on the backside of the prismatic cube corner elements. These embodiments are often referred to as "metalized retroreflective sheeting." The specular reflective coating can be applied by known techniques such as vapor depositing or chemically depositing a metal such as aluminum, silver, or nickel. A primer layer may be applied to the backside of the cube corner elements to promote the adherence of the metallic coating.

Various types of solvent-borne topcoats can be used in the embodiments described herein. Some exemplary compositions include those described in, for example, US 5,514,441 and 4,725,494. In the main embodiment, the top coat composition includes alkyd resin, polyurethane resin, epoxy resin, polyester resin, polyvinyl butyral, cellulose acetate butyrate, or vinyl chloride polymer. These resins may be applied from solution or dispersion or from liquids that contain no volatiles. The materials may be nonreactive or may react to a cross-linked relatively insoluble and infusible state.

In some embodiments, the topcoat includes a solvent-based vinyl polymer. In some embodiments, the vinyl polymer can be polymerized from a single vinyl monomer. In some embodiments, the vinyl polymer is a copolymer made from two or more vinyl monomers. In some embodiments, the vinyl polymers may have a core-shell structure. Core-shell polymers typically comprise a different copolymer with regard to either the base monomers or proportions thereof in the surrounding shell layer in comparison to the core. Core-shell polymers are generally described as two phase or multi phase polymers and may optionally contain a third phase incorporated into the same particle or as a separate particle. Other morphologies are also possible such as micro-phases, phase separated, bi-modal, multi-lobed, or inverted-core shell. In some embodiments, the vinyl polymer is a copolymer made from two or more vinyl monomers in combination with one or more monomers.

In some embodiments, the weight average molecular weight (Mw) of the solvent-borne vinyl polymer(s) is generally at least about 14,000 g/mole, more typically at least about 22,000 g/mole, more typically at least 27,000 g/mole.

In some embodiments, the topcoat includes a blend of solvent-based vinyl polymer and at least one modifying polymer. In some embodiments, the modifying polymer may comprise one or more solvent-based polymer(s). In some embodiments, the topcoat composition includes a totality of up to about 50 wt-% solids of modifying polymer(s). Alternatively, the modifying polymer and/or copolymer may be commercially available in a powdered form that may be emulsified or dispersed in solvent.

Some embodiments of the present disclosure are made by the following method: providing a sheeting having (a) a first major surface including a plurality of prismatic cube corner elements including a polycarbonate and forming a structured surface; and (b) a second major surface opposite the first major surface, the second major surface being substantially planar; and coating on at least a portion of the second major surface a topcoat having at least one of (a) a thickness of less than 0.0127 mm (when dry); or (b) at least one of a solvent-borne acrylic or a solvent-borne vinyl. Coating may be effected by, for example, processes described in U.S. Patent Nos. 7,048,989; 4,844,976; 5,508,105; and European Patent No. 0615788. Topcoats can be coated directly onto the cube corner sheeting or alternately preformed and heat laminated either during the manufacturing of the cube corner layer or in a subsequent operation. When using relatively thick, strong, thick polycarbonate layers for the cube corner sheeting, the topcoat has a minimal contribution to the physical properties of the sheeting, and polymer selection can be made based on the adhesion to the polycarbonate, dirt resistance, resistance to surface impression, etc.

In some embodiments, the topcoat includes a solvent-based acrylic polymer. In some embodiments, the acrylic polymers may be polymerized from a single acrylate monomer. In some embodiments, the acrylic polymer is a copolymer made from two or more acrylate monomers. In some embodiments, the acrylic polymers may have a core-shell structure. Core-shell polymers typically comprise a different copolymer with regard to either the base monomers or proportions thereof in the surrounding shell layer in comparison to the core. Core-shell polymers are generally described as two phase or multi phase polymers and may optionally contain a third phase incorporated into the same particle or as a separate particle. Other morphologies are also possible such as micro-phases, phase separated, bi-modal, multi-lobed, or inverted-core shell.

In some embodiments, the acrylic polymer is a copolymer made from two or more acrylate monomers in combination with styrene monomers. In some of these embodiments, the styrene content of the copolymer is typically less than about 50 wt-%, more typically less than about 30 wt-%, and most typically less than about 20 wt-%.

In some embodiments, the weight average molecular weight (Mw) of the solvent-borne acrylic polymer(s) is generally at least about 20,000 g/mole. , more typically at least about 50,000 g/mole, more typically at least 70,000 g/mole.

In some embodiments, the topcoat includes a blend of solvent-based acrylic polymer and at least one modifying polymer. In some embodiments, the modifying polymer is a solvent-borne polymer. In some embodiments, the topcoat composition includes a totality of up to about 50 wt-% solids of modifying polymer(s). Alternatively, the modifying polymer and/or copolymer may be commercially available in a powdered form that may be emulsified or dispersed in solvent.

In some embodiments, the topcoat includes additives, such as, for example, UV stabilizers. UV stabilizers are used to prevent or terminate oxidation of polymers by UV light. Suitable UV stabilizers for use in the topcoat compositions of the present disclosure are UV absorbers, quenchers and/or scavengers, and include, for example, at least one of hindered amine light stabilizers (HALS), benzophenones, benzotriazoles, triazines, and combinations thereof.

Also, the inventors of the present disclosure discovered that, in some embodiments, certain thicknesses of solvent-borne coating compositions provide a low cost alternative to the use of thick (*e.g.,* greater than 0.0127 mm when dry) topcoats. The inventors of the present disclosure discovered that, in some embodiments, a thinner coating composition thick (*e.g.,* less than 0.0127 mm when dry) provides at least one of sufficient adhesion to a retroreflective core sheet, a sheeting with high retroreflective brightness, excellent surface protection, good toner/ink adhesion properties, excellent flexibility, and/or decreased incidence of crazing or haze.

In many instances, it is desirable to seal the retroreflective sheeting and thereby to protect the optical elements (*e.g.,* cube corner elements and lenslets) from environmental degradation. Inclusion of a sealing layer in the sheeting prevents or limits entry of soil or moisture into the sheeting. Some exemplary methods of applying of a sealing layer are described in U.S. Patent Nos. 7,329,447; 7,611,251; 5,784,197; 4,025,159 (disclosing use of electron beam radiation); 5,706,132 (use of thermal bonding or radio frequency welding); PCT Publication WO 2011/152977 (describing multi-layer sealing films for prismatic retroreflective sheeting); and. 6,224,792 (hermetic encapsulation by the sealing layer).

Some embodiments include a structured sealing layer. An exemplary structured sealing layer is described in, for example, in PCT Patent Publication No. WO 2011/129832.

In some embodiments, the retroreflective sheeting lacks either a sealing films and/or a specular reflective or metal coating on the cube corner elements. Exemplary sheeting constructions are described in, for example, in PCT Patent Publication No. WO 2011/129832.

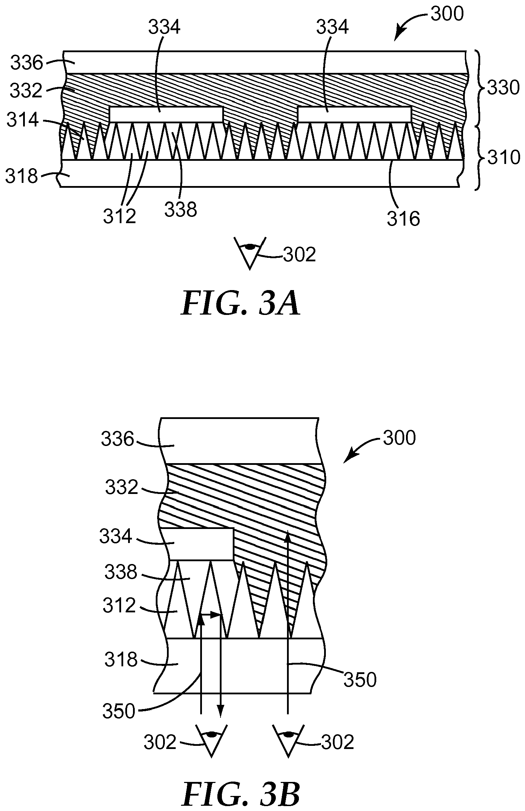

FIGS. 3A and 3B show one exemplary embodiment of a retroreflective article 300 that faces viewer 302. Retroreflective article 300 includes a retroreflective layer 310 including multiple cube corner elements 312 that collectively form a structured surface 314 opposite a major surface 316. Retroreflective layer 310 also includes a topcoat / overlay layer 318. A pressure sensitive adhesive layer 330 is adjacent to retroreflective layer 310. Pressure sensitive adhesive layer 330 includes a pressure sensitive adhesive 332, one or more barrier layers 334, and a liner 336. Barrier layer 334 has sufficient structural integrity to prevent pressure sensitive adhesive 332 from flowing into a low refractive index layer 338 that is between structured surface 314 and barrier layer 334. Barrier layer 334 can directly contact or be spaced apart from or can push slightly into the tips of cube corner elements 312.

Where present, barrier layers 334 form a physical "barrier" between pressure sensitive adhesive 330 and cube corner elements 312. Barrier layers may prevent wetting of cube tips or surfaces by the pressure sensitive either initially during fabrication of the retroreflective article or over time due to the to viscoelastic nature of the adhesive. A trapped layer between barrier layers 334 (where present) and cube corner elements 312 is low refractive index layer 338. Low refractive index layer is thereby enclosed. If a protective layer is applied thereto, the low refractive index layer is encapsulated. Encapsulation of the low refractive index layer maintains and/or protects the integrity of the low refractive index layer. The presence of the barrier layer permits the portions of structured surface 314 adjacent to low refractive index layer 338 and/or barrier layers 334 to retroreflect incident light 350. Barrier layers 334 may also prevent pressure sensitive adhesive 330 from wetting out the cube sheeting. Pressure sensitive adhesive 330 that is not in contact with a barrier layer 334 adheres to the cube corner elements, thereby effectively sealing the retroreflective areas to form optically active areas or cells. Pressure sensitive adhesive 330 also holds the entire retroreflective construction together, thereby eliminating the need for a separate sealing film and sealing process. In some embodiments, the pressure sensitive adhesive is in intimate contact with or is directly adjacent to the structured surface or the cube corner elements.

As is shown in FIG. 3B, a light ray 350 incident on a cube corner element 312 that is adjacent to low refractive index layer 338 is retroreflected back to viewer 302. For this reason, an area of retroreflective article 300 that includes low refractive index layer 338 is referred to as an optically active area. In contrast, an area of retroreflective article 300 that does not include low refractive index layer 338 is referred to as an optically inactive area because it does not substantially retroreflect incident light.

Low refractive index layer 338 includes a material that has a refractive index that is less than about 1.30, less than about 1.25, less than about 1.2, less than about 1.15, less than about 1.10, or less than about 1.05. Exemplary low refractive index materials include air and low index materials (*e.g*., low refractive index materials described in U.S. Patent Application No. 61/3.

In general, any material that prevents the pressure sensitive adhesive from contacting cube corner elements 312 or flowing or creeping into low refractive index layer 338 can be used in barrier layer 334. Exemplary materials for use in barrier layer 334 include resins, polymeric materials, dyes, inks, vinyl, inorganic materials, UV-curable polymers, pigment, particle, and bead. The size and spacing of the barrier layers can be varied. In some embodiments, the barrier layers may form a pattern on the retroreflective sheeting. In some embodiments, one may wish to reduce the visibility of the pattern on the sheeting. In general, any desired pattern can be generated by combinations of the described techniques, including, for example, indicia such as letters, words, alphanumerics, symbols, or even pictures. The patterns can also be continuous, discontinuous, monotonic, serpentine, any smoothly varying function, stripes, varying in the machine direction, the transverse direction, or both; the pattern can form an image, logo, or text, and the pattern can include patterned coatings and/or perforations. In some embodiments, the printed areas and/or unprinted areas can form a security feature. The pattern can include, for example, an irregular pattern, a regular pattern, a grid, words, graphics, images lines, and intersecting zones that form cells.

In at least some embodiments, the pressure sensitive adhesive layer includes a first region and a second region. The second region is in direct or intimate contact with the structured surface. The first and second regions have sufficiently different properties to form and separate the low refractive index layer between and from the pressure sensitive adhesive layer and the structured surface of the retroreflective layer. In some embodiments, the second region includes a pressure sensitive adhesive and the first region differs in composition from the second region. In some embodiments, the first region and the second region have different polymer morphology. In some embodiments, the first region and the second region have different flow properties. In some embodiments, the first region and the second region have different viscoelastic properties. In some embodiments, the first region and the second region have different adhesive properties. In some embodiments, the retroreflective article includes a plurality of second regions that form a pattern. In some embodiments, the pattern is one of an irregular pattern, a regular pattern, a grid, words, graphics, and lines.

Exemplary pressure sensitive adhesives for use in the retroreflective articles of the present disclosure include those described in PCT Patent Publication No. WO 2011/129832.

Solvent-based topcoats have not been used until the present disclosure because solvent coating a polycarbonate typically causes crazing or haze. As used herein, the terms "craze" or "crazing" relate generally to macroscopic tension failure in a thermoplastic polymer. Crazing occurs before total tension failure of the thermoplastic polymer. The crazes appear stochastically depending on the distribution of microscopic defects within and at the surface of a material. Crazes include voids that typically extend perpendicular to the tensile strain. Often, the tip of the craze will contain fibrils of polymer chains that extend from one surface to the other across the tip parallel to the tension. Once a craze reaches a critical state, it typically either (1) propagates into a crack that grows to a macroscopic fracture or (2) the material yields. Crazing causes an increase in whiteness and an undesirable increase in haze of the sheeting.

As used herein, the term "haze" refers to cloudiness in the sheeting caused by scattering of incident light. Haze can occur in addition to or separate from crazing, and is an undesirable property in retroreflective sheeting because it decreases the retroreflectivity of the sheeting and/or can cause yellowing of the sheeting. Without being limited by theory, it is thought that solvents penetrate into the polycarbonate of the retroreflective sheeting and cause the polycarbonate to crystallize, which may cause undesirable hazing. Small amounts of either or both haze or craze result in significant decrease in retroreflectivity. For at least this reason, solvent-based topcoats have not been used until the present disclosure.

The inventors of the present disclosure discovered that a solvent-based topcoat could be used with minimal to no crazing if at least one of the following conditions was present: (1) the topcoat layer is very thin (*e.g.,* less than 0.5 mils when dry); (2) the exposure time of the topcoat coating on the polycarbonate is very minimal (*e.g.,* less than 15 seconds, or less than 12 seconds, or less than 10 seconds, or less than 9 seconds, or less than 7 seconds, or less than 5 seconds, etc). Without being limited to theory, it is thought that by driving off the solvent quickly, the solvent molecules are largely prevented from diffusing into the polycarbonate, which is thought to contribute to the creation of haze and/or crazing. It was highly unexpected that a polycarbonate sheeting could be stabilized with a coating of such a minimal thickness.

The retroreflective sheeting of the present disclosure has numerous advantages over existing sheeting and methods of making the sheeting. One advantage is that solvent coating directly onto a polycarbonate is achieved with minimal to no crazing and/or without sacrificing durability and/or weatherability.

The retroreflective sheeting described herein may be used for a variety of uses such as traffic signs, license plates, pavement marking (*e.g*. raised pavement markings), personal safety, vehicle decoration, and commercial graphics such as retroreflective advertising displays, bus wraps, etc.

Objects and advantages of the invention are further illustrated by the following examples, but the particular materials and amounts thereof recited in the examples, as well as other conditions and details, should not be construed to unduly limit the invention. All percentages and ratios herein are by weight unless otherwise specified. The following examples are not intended to limit the scope of the present disclosure.

As used herein, the words "on" and "adjacent" cover both a layer being directly on and indirectly on something, with other layers possibly being located therebetween.

As used herein, the terms "major surface" and "major surfaces" refer to the surface(s) with the largest surface area on a three-dimensional shape having three sets of opposing surfaces.

Unless otherwise indicated, all numbers expressing feature sizes, amounts, and physical properties used in the present disclosure and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein. All numerical ranges are inclusive of their endpoints and non-integral values between the endpoints unless otherwise stated.

As used in this specification and the appended claims, the singular forms "a", "an", and "the" encompass embodiments having plural referents, unless the content clearly dictates otherwise.

As used in this disclosure and the appended claims, the term "or" is generally employed in its sense including "and/or" unless the content clearly dictates otherwise.

The phrases "at least one of' and "comprises at least one of' followed by a list refers to any one of the items in the list and any combination of two or more items in the list.

## Claims

1. Retroreflective sheeting, comprising:
a first major surface (130) that is a structured surface having a structure imparted by a plurality of prismatic cube corner elements (140);
a second major surface (150) opposite the first major surface, the second major surface being substantially planar and;
a topcoat (120) having a thickness of less than 0.0127mm (0.5 mil) when dry adjacent to at least a portion of the second major surface, wherein the topcoat is a solvent-based composition comprising at least one of alkyd resin, polyurethane resin, epoxy resin, polyester resin, polyvinyl butyral, cellulose acetatebutyrate, or vinyl chloride copolymer;
**characterized in that** the second major surface comprises polycarbonate and the topcoat includes between 3% by weight and about 10% by weight of a UV absorber.

2. The retroreflective sheeting of any of the preceding claims, wherein the plurality of prismatic cube corner elements include at least one of truncated cube corner elements, full cube corner elements, or preferred geometry cube corner elements.

3. The retroreflective sheeting of any of the preceding claims, wherein the second major surface is part of at least one of (1) a land layer or (2) a body layer.

4. The retroreflective sheeting of any of the preceding claims, wherein the plurality of prismatic cube corner elements comprises a thermoplastic polymer.

5. The retroreflective sheeting of claim 4, wherein the thermoplastic polymer is at least one of an acrylic polymer, a polycarbonate, a polyester, a polyimide, a fluoropolymer, a polyamide, a polyetherketone; a poly(etherimide); a polyolefin; a poly(phenylene ether); a poly(styrene); a styrene copolymer; a silicone modified polymer; a cellulosic polymer; a fluorine modified polymer; and mixtures of the above polymers.

6. The retroreflective sheeting of any of the preceding claims, wherein the topcoat comprises multiple layers and the layers are the same as one another.

7. The retroreflective sheeting of any of the preceding claims, wherein the topcoat comprises multiple layers and the layers differ from one another.

8. The retroreflective sheeting of any of the preceding claims, further comprising:
a seal film.

9. The retroreflective sheeting of any of the preceding claims, wherein the amount of one or more of crazing or haze reduces retroreflective brightness by less than 90%.

10. The retroreflective sheeting of any of the preceding claims, wherein the topcoat comprises at least one of vinyl or acrylic.

11. The retroreflective sheeting of any of the preceding claims, further comprising a specular reflective coating.

12. The retroreflective sheeting of any of the preceding claims, wherein the solvent-based composition comprises an acrylic polymer made from two or more acrylate monomers.

13. The retroreflective sheeting of claim 12, wherein the acrylate copolymer comprises styrene.

## Patentansprüche

1. Rückstrahlende Folie, aufweisend:
eine erste Hauptoberfläche (130),
die eine strukturierte Oberfläche mit einer Struktur ist, die durch eine Mehrzahl von prismatischen Würfeleckenelementen (140) verliehen wird;
eine zweite Hauptoberfläche (150)
gegenüber der ersten Hauptoberfläche, wobei die zweite Hauptoberfläche im Wesentlichen eben ist und;
eine Deckschicht (120) mit einer Dicke von weniger als 0,0127 mm (0,5 mil) im trockenen Zustand, angrenzend an mindestens einen Abschnitt der zweiten Hauptoberfläche, wobei die Deckschicht eine Zusammensetzung auf Lösungsmittelbasis ist, die mindestens eines von Alkydharz, Polyurethanharz, Epoxidharz, Polyesterharz, Polyvinylbutyral, Celluloseacetatbutyrat oder Vinylchloridcopolymer aufweist;
**dadurch gekennzeichnet, dass** die zweite Hauptoberfläche Polycarbonat aufweist und die Deckschicht zwischen 3 Gew.-% und etwa 10 Gew.-% eines UV-Absorptionsmittels enthält.

2. Rückstrahlende Folie nach einem der vorstehenden Ansprüche, wobei die Mehrzahl von prismatischen Würfeleckenelementen mindestens eines von abgeschnittenen Würfeleckenelementen, Vollwürfeleckenelementen oder Würfeleckenelementen bevorzugter Geometrie einschließt.

3. Rückstrahlende Folie nach einem der vorstehenden Ansprüche, wobei die zweite Hauptoberfläche Teil von mindestens einem von (1) einer Stegschicht oder (2) einer Körperschicht ist.

4. Rückstrahlende Folie nach einem der vorstehenden Ansprüche, wobei die Mehrzahl von prismatischen Würfeleckenelementen ein thermoplastisches Polymer aufweist.

5. Rückstrahlende Folie nach Anspruch 4, wobei das thermoplastische Polymer mindestens eines von einem Acrylpolymer, einem Polycarbonat, einem Polyester, einem Polyimid, einem Fluorpolymer, einem Polyamid, einem Polyetherketon; einem Poly(etherimid); einem Polyolefin; einem Poly(phenylenether); einem Poly(styrol); einem Styrolcopolymer; einem silikonmodifizierten Polymer; einem Cellulosepolymer; einem fluormodifizierten Polymer; und Mischungen der obigen Polymere ist.

6. Rückstrahlende Folie nach einem der vorstehenden Ansprüche, wobei die Deckschicht mehrere Schichten aufweist und die Schichten einander gleich sind.

7. Rückstrahlende Folie nach einem der vorstehenden Ansprüche, wobei die Deckschicht mehrere Schichten aufweist und sich die Schichten voneinander unterscheiden.

8. Rückstrahlende Folie nach einem der vorstehenden Ansprüche, ferner aufweisend:
eine Siegelfolie.

9. Rückstrahlende Folie nach einem der vorstehenden Ansprüche, wobei die Menge von einem oder mehreren von Haarrissbildung oder Trübung rückstrahlende Helligkeit um weniger als 90 % reduziert.

10. Rückstrahlende Folie nach einem der vorstehenden Ansprüche, wobei die Deckschicht mindestens eines von Vinyl oder Acryl aufweist.

11. Rückstrahlende Folie nach einem der vorstehenden Ansprüche, ferner aufweisend eine spekulare rückstrahlende Beschichtung.

12. Rückstrahlende Folie nach einem der vorstehenden Ansprüche, wobei die Zusammensetzung auf Lösungsmittelbasis ein Acrylpolymer aufweist, das aus zwei oder mehr Acrylatmonomeren hergestellt ist.

13. Rückstrahlende Folie nach Anspruch 12, wobei das Acrylatcopolymer Styrol aufweist.

## Revendications

1. Revêtement en feuille rétroréfléchissant, comprenant :
une première surface principale (130)
qui est une surface structurée ayant une structure conférée par une pluralité d'éléments à trièdres trirectangles prismatiques (140) ;
une deuxième surface principale (150)
opposée à la première surface principale, la deuxième surface principale étant sensiblement plane et ;
une couche supérieure (120) ayant une épaisseur inférieure à 0,0127 mm (0,5 mil) lorsqu'elle est sèche adjacente à au moins une partie de la deuxième surface principale, dans lequel la couche supérieure est une composition à base de solvant comprenant au moins l'un parmi une résine alkyde, une résine polyuréthane, une résine époxy, une résine polyester, du polyvinyl-butyral, de l'acétate-butyrate de cellulose, ou un copolymère de chlorure de vinyle ;
**caractérisé en ce que** la deuxième surface principale comprend du polycarbonate et la couche supérieure inclut entre 3 % en poids et environ 10 % en poids d'un absorbeur UV.

2. Revêtement en feuille rétroréfléchissant selon l'une quelconque des revendications précédentes, dans lequel la pluralité d'éléments à trièdres trirectangles prismatiques inclut au moins l'un parmi des éléments à trièdres trirectangles tronqués, des éléments à trièdres trirectangles complets, ou des éléments à trièdres trirectangles de géométrie préférée.

3. Revêtement en feuille rétroréfléchissant selon l'une quelconque des revendications précédentes, dans lequel la deuxième surface principale fait partie d'au moins l'une parmi (1) une couche de méplat ou (2) une couche de corps.

4. Revêtement en feuille rétroréfléchissant selon l'une quelconque des revendications précédentes, dans lequel la pluralité d'éléments à trièdres trirectangles prismatiques comprend un polymère thermoplastique.

5. Revêtement en feuille rétroréfléchissant selon la revendication 4, dans lequel le polymère thermoplastique est au moins l'un parmi un polymère acrylique, un polycarbonate, un polyester, un polyimide, un fluoropolymère, un polyamide, une polyéthercétone ; un poly(étherimide) ; une polyoléfine ; un poly(éther de phénylène) ; un poly(styrène) ; un copolymère de styrène ; un polymère à modification silicone ; un polymère cellulosique ; un polymère à modification fluor ; et des mélanges des polymères ci-dessus.

6. Revêtement en feuille rétroréfléchissant selon l'une quelconque des revendications précédentes, dans lequel la couche supérieure comprend de multiples couches et les couches sont identiques les unes aux autres.

7. Revêtement en feuille rétroréfléchissant selon l'une quelconque des revendications précédentes, dans lequel la couche supérieure comprend de multiples couches et les couches diffèrent les unes des autres.

8. Revêtement en feuille rétroréfléchissant selon l'une quelconque des revendications précédentes, comprenant en outre :
un film d'étanchéité.

9. Revêtement en feuille rétroréfléchissant selon l'une quelconque des revendications précédentes, dans lequel la quantité d'un ou plusieurs parmi un faïençage ou un trouble réduit la luminosité rétroréfléchissante de moins de 90 %.

10. Revêtement en feuille rétroréfléchissant selon l'une quelconque des revendications précédentes, dans lequel la couche supérieure comprend au moins l'un parmi vinyle ou acrylique.

11. Revêtement en feuille rétroréfléchissant selon l'une quelconque des revendications précédentes, comprenant en outre un revêtement réfléchissant spéculaire.

12. Revêtement en feuille rétroréfléchissant selon l'une quelconque des revendications précédentes, dans lequel la composition à base de solvant comprend un polymère acrylique fabriqué à partir de deux monomères acrylate ou plus.

13. Revêtement en feuille rétroréfléchissant selon la revendication 12, dans lequel le copolymère acrylate comprend du styrène.
